# EUROPEAN PATENT APPLICATION

(11) **EP 1 873 917 A1**
(43) Date of publication of application: **02.01.2008**
(21) Application number: 06013607.4
(22) Date of filing: 30.06.2006
(51) Int. Cl.: H03K 17/082, H03K 17/16

(54) **Circuit arrangment with at least two semiconductor switches**

(71) Applicant: Infineon Technologies Austria AG, 9500 Villach (AT)
(72) Inventor: Logiudice, Andrea, 35136 Padova (IT); Pastorina, Salvatore, 95100 Catania (IT); Scenini, Andrea, 35031 Abano Terme (IT); Wotruba, Bernhard, 35132 Padova (IT)
(74) Representative: Bickel, Michael

(57) **Abstract**

The invention relates to a circuit arrangement comprising
a first semiconductor switch (T1) and at least one second semiconductor switch (Tn), each of them having a control terminal (11, 1n) and a first (21, 2n) and second (31, 3n) load terminal, and with
at least one overvoltage protection arrangement for the at least two semiconductor switches (T1, Tn),
a coupling circuit (90) for selectively coupling the control terminals of at least two of the at least two semiconductor switches.

## Description

The present invention relates to a circuit arrangement with at least two semiconductor switches and with an overvoltage protection for the at least two semiconductor switches.

Semiconductor switches such as MOSFETs or IGBTs are being used increasingly for switching electrical loads, such as switching electrical consumers in motor vehicles. In order to be able to actuate several consumers by means of a single integrated circuit, several semiconductor switches, in particular several power MOSFETs, are integrated in a semiconductor chip. An integrated circuit with two power MOSFETs integrated in a chip is, for example, the integrated circuit HITFET^{®} BTS 3410 G, which is described in data sheet 2004-03-05 of Infineon Technologies AG, Munich.

Such an integrated circuit with several semiconductor switches has circuits available separately for each of the semiconductor switches. Such circuits are, for example, driver circuits, one of which is assigned to each semiconductor switch, or protection circuits, such as current limiting circuits, overheating circuits, overvoltage protection circuits, or circuits to prevent overloading, one of each being assigned to each semiconductor switch.

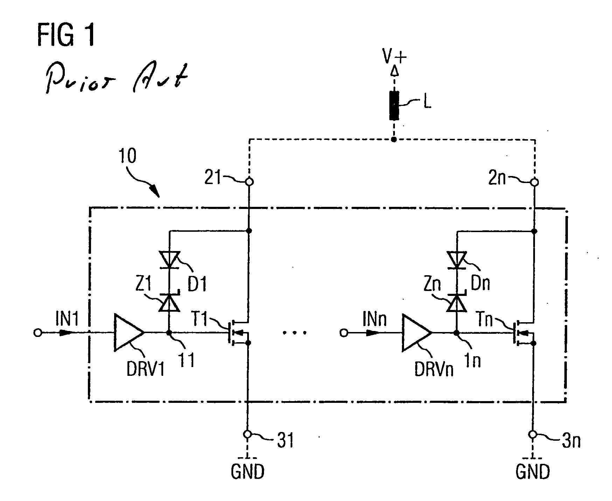

The overvoltage protection circuits are, in particular, protection circuits working on the principle of "active Zenering". This principle is likewise presented in the above-mentioned data sheet for the BTS 3410 G and will be explained hereinbelow with reference to Figure 1.

Figure 1 shows a circuit arrangement with two semiconductor switches T1, Tn, configured as a MOSFET, each of them having one control terminal 11, 1n as well as first load terminals 21, 2n and second load terminals 31, 3n. Semiconductor switches T1, Tn are actuated via driver circuits DRV1, DRVn depending on input signals IN1, INn fed to the driver circuits DRV1, DRVn. The semiconductor switches T1, Tn and the driver circuits DRV1, DRVn are integrated together in a semiconductor chip, as is indicated in Figure 1 schematically by the dot-and-dash line indicated as 10.

To protect the semiconductor switches T1, Tn against an overvoltage between their load terminals 21, 31 and 2n, 3n, each of the semiconductor switches T1, Tn has a protection circuit with a diode D1, Dn and a Zener diode Z1, Zn, which are connected between the first load terminals 21, 2n and the control terminals 11, 1n of the semiconductor switches T1, Tn. If, during the operation of this semiconductor switch, an electrical potential at the first load terminal 21, 2n rises to a value lying above the potential on the control terminals 11, 1n by the value of the breakthrough voltage of the Zener diodes Z1, Zn of the protection circuits, the semiconductor switches T1, Tn will be biased into conduction, thereby preventing a further rise in the voltage across their loads and protecting the semiconductor switches T1, Tn against overvoltage.

One problem with providing separate overvoltage protection circuits for the at least two semiconductor switches can arise in the situation represented by the dotted line in Figure 1, when the two semiconductor switches T1, Tn jointly actuate an inductive load L. The load in this case is connected between a terminal for a positive power supply potential V+ and the first load terminals 21, 2n of the two semiconductor switches T1, Tn, while the second load terminals 31, 3n of the semiconductor switches T1, Tn lie at a reference potential GND. Thus, the two semiconductor switches T1, Tn are connected up in parallel for the actuation of the inductive load L. Such a parallel circuit can be required when the current uptake of the load L is higher than the maximum allowable current load of one of the semiconductor switches T1, Tn.

If, in this circuit configuration, the two semiconductor switches T1, Tn are caused to go into conduction, a load current will flow through the inductive load, being shared between the two semiconductor switches T1, Tn. If the two semiconductor switches T1, Tn are then switched off, the voltage on their first load terminals 21, 2n will rise on account of the energy accumulated in the inductive load. If this potential reaches a value where the Zener diodes Z1, Zn conduct a current to the control terminals 11, 1n of the semiconductor switches T1, Tn, the two semiconductor switches T1, Tn will go into conduction to prevent a further rise in the electrical potential at the first load terminals 21, 2n and commutate the inductive load away.

If the Zener diodes Z1, Zn differ in their breakthrough voltage due to manufacturing variations, an operating situation may result in which one of the two semiconductor switches T1, Tn is conducting, while the other is still blocking. The conducting semiconductor switch will then have the entire commutation current of the inductive load flowing through it, which can result in an overstress that can lead to destruction of this semiconductor switch. In this connection, it should be noted that, instead of only one Zener diode, it is customary to provide series circuits of several Zener diodes, which somewhat aggravates the problem of manufacturing-caused variations.

The load paths of semiconductor switches T1, Tn may be connected in parallel for driving one common load. However, balancing the load currents in order to have the different switches driving the same current through the load Z is not trivial.

The problem of the present invention is to provide a circuit arrangement with at least two semiconductor switches which - when the at least two switches commonly drive a load - provides improved current sharing.

This problem is solved by a circuit arrangement according to Claim 1. Advantageous embodiments of the invention are the subjects of the dependent claims.

The circuit arrangement according to the invention comprises a first semiconductor switch and at least one second semiconductor switch, each of them having a control terminal and a first and a second load terminal, at least one overvoltage protection arrangement for the at least two semiconductor switches, and a coupling circuit for selectively coupling the control terminals of at least two of the at least two semiconductor switches.

Under operating conditions, in which the at least two semiconductor switches drive one common load, coupling the control terminals of the semiconductor switches helps operating the switches in at least almost identical operating points, thereby improving current sharing.

The circuit arrangement may have a central overvoltage protection for the at least two semiconductor switches, or individual overvoltage protections may be provided for each of the semiconductor switches.

The central overvoltage protection arrangement has a voltage limiting unit with a first and a second terminal, whose first terminal is connected to a central circuit node and whose second terminal is connected to a terminal for a reference potential. The voltage limiting unit is configured so that, when a predetermined threshold voltage is applied between the first and second load terminals, it conducts a current. The overvoltage protection arrangement, furthermore, has a first actuating circuit for the first semiconductor switch and a second actuating circuit for the at least one second semiconductor switch. Each of these actuating circuits comprises a current sensor, which is connected between the first load terminal of the particular semiconductor switch and the central circuit node, and a current source which is actuated by the current sensor, being connected to the control terminal of the particular semiconductor switch.

In this overvoltage protection arrangement, where the voltage limiting unit is coupled via the central circuit node to the first load terminals of the semiconductor switches, the voltage limiting unit conducts a current when the potential at the first load terminal rises by the value of the threshold voltage of the voltage limiting unit above the value of a reference potential. This current flowing across the voltage limiting unit serves the purpose, via the current sensor and the current source of the actuating circuit belonging to this semiconductor switch, of biasing this semiconductor switch into conduction in order to counteract a further rising of the potential of the load portion of the circuit.

The voltage limiting unit in this circuit arrangement can comprise a Zener diode or a series connection with several Zener diodes. The breakthrough voltage of this Zener diode or of the series connection with several Zener diodes will determine the threshold voltage at which a current will flow from the central circuit node, to which all of the first load terminals of the semiconductor switches are connected to, across the voltage limiting unit.

As an alternative, it is possible to provide an additional semiconductor switch in the voltage limiting unit, which is actuated by a Zener diode or by a series connection with several Zener diodes.

In one embodiment, the current sensor and the current source of the actuating circuit of a semiconductor switch are realized such that they form a current mirror, which maps a current flowing from the first load terminal of the particular semiconductor switch to the central circuit node onto a current at the control terminal of the particular semiconductor switch.

In another embodiment, the current sensor of the actuating circuit of a semiconductor switch is realized as a resistor and the current source as a transistor, which is controlled by a voltage drop across the resistor.

The present invention will now be explained in greater detail with reference to the drawings.
- Figure 1: shows a circuit arrangement with two semiconductor switches according to the prior art, each of which is connected to its own overvoltage protection circuit.
- Figure 2: shows a circuit arrangement with at least two semi-conductor switches, having a central overvoltage protection arrangement for the semiconductor switches.
- Figure 3: shows a first exemplary embodiment of a voltage limiting unit of the overvoltage protection arrangement.
- Figure 4: shows a second exemplary embodiment of a voltage limiting unit of the overvoltage protection arrangement.
- Figure 5: shows a second exemplary embodiment of a circuit arrangement having a central overvoltage protection arrangement.
- Figure 6: shows a third exemplary embodiment of a circuit arrangement having a central overvoltage protection arrangement.
- Figure 7: shows a circuit arrangement with at least two semi-conductor switches and a coupling circuit for electrically coupling the control terminals of at least two semiconductor switches.
- Figure 8: shows a circuit arrangement with at least two semi-conductor switches, a coupling circuit and a central overvoltage protection arrangement.

In the figures, unless otherwise stated, the same reference numbers designate the same circuit components and signals with the same meaning.

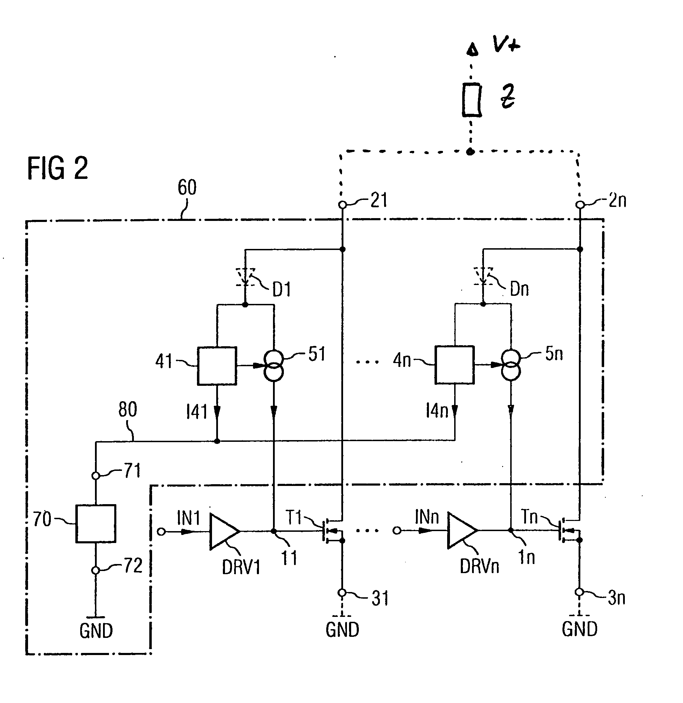

Figure 2 shows a first embodiment of a circuit arrangement according to the invention, having two semiconductor switches T1, Tn, each of which has a control terminal 11, 1n, a first load terminal 21, 2n and a second load terminal 31, 3n. The semiconductor switches T1, Tn in the example are realized as n-channel-MOSFETs, whose drain terminals form the first load terminals 21, 2n, whose source terminals form the second load terminals 31, 3n and whose gate terminals form the control terminals 11, 1n. The semiconductor switches T1, Tn in the example are connected as low-side switches.

To each of the control terminals 11, 1n of these semiconductor switches T1, Tn driver circuits DRV1, DRVn are connected, which serve to convert actuating signals IN1, INn, by which the semiconductor switches T1, Tn are to be made conducting or blocking, to suitable levels for actuating these semiconductor switches T1, Tn.

The two semiconductor switches T1, Tn can be actuated separately from each other via the actuating signals IN1, INn and thereby serve to actuate different loads, not shown in greater detail in Figure 2, independently of each other. These loads are to be connected in series with the load paths of the semiconductor switches T1, Tn with these series circuits are to be connected between terminals for a power supply potential and a reference potential.

The two semiconductor switches T1, Tn and their driver circuits DRV1, DRVn are integrated in a manner not depicted in greater detail, preferably jointly in a semiconductor body or a semiconductor chip.

A common overvoltage protection circuit 60 is provided to protect the two semiconductor switches T1, Tn against overvoltage on their load sections. This overvoltage protection circuit 60 comprises a voltage limiting unit 70 with a first and a second terminal 71, 82, the first terminal 71 being connected to a central circuit node 80 and the second terminal 72 being connected to a terminal for a reference potential GND. This reference potential GND can be, in particular, the reference potential to which all voltages are referred in an application circuit in which the depicted circuit arrangement is employed. This reference potential GND can be, in particular, the ground potential.

The first terminal 71 of the voltage limiting unit is coupled via the central circuit node 80 to the first load terminals 21, 2n of the semiconductor switches T1, Tn. Between each of the first load terminals 21, 2n and the central circuit node 80 there is connected a current sensor 41, 4n. Each of these current sensors 41, 4n actuates a current source 51, 5n, which is conncted to the control terminal 11, 1n of the respective semiconductor switch T1, Tn. These current sources 51, 5n in the example shown are connected between the first load terminals 21, 2n and the control terminals 11, 1n of the semiconductor switches T1, Tn and are thus energized by the potential at the first load terminals 21, 2n.

In a manner not shown in greater detail, it is also possible to connect the terminals 51, 5n of the current sources away from the control terminals 11, 1n to a different power supply potential than the load potentials of the first semiconductor switches 21, 2n, which must be chosen such that it is sufficient to actuate the semiconductor switches in conduction.

In the context of the present invention, "current source" describes a circuit arrangement that is controlled by one of the current sensors and furnishes a current to the control terminal of the respective semiconductor switch. This current source can also be realized, in a manner not specifically illustrated, as a switch that is controlled by the respective current sensor and whose load path is connected between a terminal for a power supply potential and the control terminal of the respective semiconductor switch.

Optionally, rectifiers D1, Dn are connected between the first load terminals 21, 2n and the current sensors 41, 4n. These rectifiers D1, Dn are realized in the example of Figure 2 as diodes and during operating states where the semiconductor switches T1, Tn are actuated into conduction via the driver circuits DRV1, DRVn they prevent the charge of the gate electrodes of the MOSFETs T1, Tn from flowing away across their load section and they prevent a current from flowing away from the central circuit node 80 across the load paths of the semiconductor switches T1, Tn.

The functioning of the circuit arrangement depicted in Figure 2 will now be explained by means of the first semiconductor switch T1 and its actuation circuit, which comprises the current sensor 41 and the current source 51. For this, let it first be assumed that the semiconductor switch T1 is actuated into blocking via the actuation signal IN1 and the driver circuit DRV1. If, during this process, the load potential at the first load terminal 21 - for example, due to an inductive load connected to it - increases to a value that corresponds to the threshold voltage of the voltage limiting unit 70 plus the forward voltage of the diode D1, a current I41 will flow from the first load terminal 21 across the diode D1, the current sensor 41, and the voltage limiting unit 70 to reference potential GND. The current sensor 41 detects this current flow and actuates the current source 51, so that the latter delivers a current I51 to the control terminal 11 of the semiconductor switch T1. The semiconductor switch T1 is thereby biased into conduction so as to counteract any further rise in the load potential or, in case of an inductive load connected to the first load terminal 21, to commutate this inductive load away.

The overvoltage protection function explained above operates accordingly for the second semiconductor switch Tn, when a potential rises at the first load terminal 2n of this second semiconductor switch Tn. In this case, the current sensor 4n actuates the current source 5n hooked up to the control terminal 1n of this semiconductor switch Tn, thereby biasing the semiconductor switch Tn into conduction. The overvoltage protection function in this overvoltage protection circuit is also present when the load potentials at both semiconductor switches T1, Tn increase to values above the threshold voltage of the voltage limiting unit 70. In this case, currents flow from both first load terminals 21, 2n across the diodes D1, Dn and the current sensors 41, 4n as well as the voltage limiting unit 70 to reference potential GND. These currents are detected by the current sensors 41, 4n, which in turn actuate the current sources 51, 5n.

The circuit arrangement depicted in Figure 2 contains two "channels", each with a semiconductor switch. This circuit, of course, can be expanded to more than two semiconductor switches T1, Tn, as suggested in Figure 2. Each "channel" added in addition to this circuit comprises a semiconductor switch with a driver circuit, as well as an actuating circuit, having a current sensor and a current source. The current sensor is connected, similarly to the current sensors 41, 4n presented in Figure 2, between a first load terminal of this additional semiconductor switch and the central circuit node 80.

Referring to figure 2 the at least two semiconductor switches T1, Tn may be used for driving one common load Z. In this case, the load paths of the two switches T1, Tn are connected in parallel. The parallel circuit of the at least two switches is connected in series to the load Z, with the series circuit being connected between terminals for a first and a second supply potential V+, GND. The central overvoltage protection circuit 60 of the circuit arrangement improves current sharing between the at least two switches T1, Tn if an overvoltage occurs at the circuit node common to the load Z and the load paths of the semiconductor switches. In case of such overvoltage the overvoltage protection circuit 60 turns the switches T1, Tn connected in parallel into conduction, thereby distributing the overall current equally to the switches.

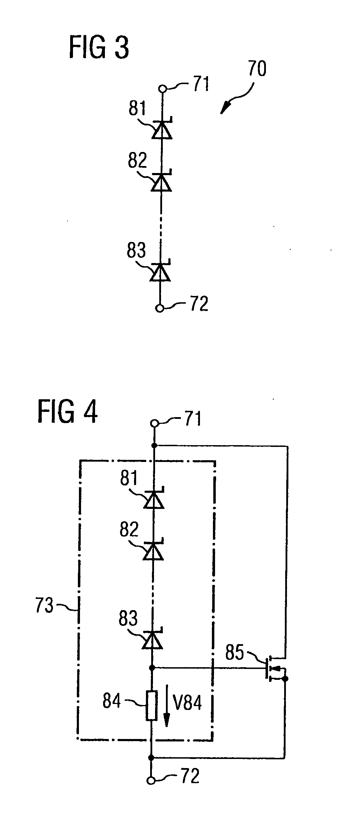

Figure 3 shows one possible exemplary embodiment for the voltage limiting unit 70. The voltage limiting unit in this case has a series circuit with several Zener diodes 81, 82, 83, being connected between the first and second terminals 71, 72. The breakthrough voltage of this series circuit with several Zener diodes 81, 82, 83 determines the threshold voltage at which the voltage limiting unit 70 will conduct a current between the first and second terminal 71, 72.

Figure 4 shows another exemplary embodiment of such a voltage limiting unit. The voltage limiting unit in this case has a series circuit of several Zener diodes 81, 82, 83 and a resistor 84 between the first and second terminals 71, 72. Connected in parallel with this series circuit is the load path of another semiconductor switch, in the example an n-channel MOSFET 85. This MOSFET 85 is actuated by a voltage V84 across the resistor 84 and is conducting when the voltage between the first and second terminals 71, 72 is larger than the breakthrough voltage of the Zener diode chain 81-83 plus the threshold voltage of the MOSFET 85. Since the threshold resistance of the MOSFET 85 is lower than the forward resistance of the Zener diode chain operating in the blocking direction, the MOSFET 85 takes up the main share of the current flowing between the first and second terminals 71, 72. The current load on the Zener diodes 81-83 is therefore less than the current load on the Zener diodes in a voltage limiting unit according to Figure 3, so that in the voltage limiting unit according to Figure 4 the Zener diodes 81-83 can be smaller in dimension that the corresponding Zener diodes in the circuit of Figure 3. Despite the additional MOSFET 85, the voltage limiting unit of Figure 4 is more space-saving. Furthermore, the clamping voltage of the voltage limiting unit 73 in Figure 4 is less dependant on the currents I41, ..., I4n flowing into the voltage limiting unit 73.

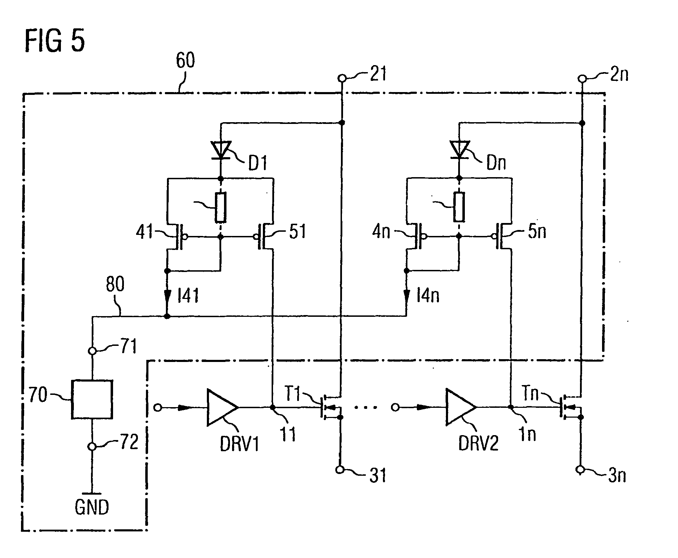

Figure 5 shows an exemplary embodiment of a circuit according to the invention, in which a current sensor 41 and a current source 51 are jointly realized as current mirrors. The current sensor 41 in this case forms an input transistor of the current mirror, while the current source 51 forms an output transistor of this current mirror. A current I41 flowing through the input transistor 41 is mapped in this arrangement via the output transistor 51 onto a current I51 at the control terminal 11 of the semiconductor switch T1. The current mirror 41, 51 can be of such a dimension that the current I41 corresponds to the current I51. Moreover, it is possible to adjust the output current I51 of the current mirror through the surface ratio of the transistors 41, 51 forming the current mirror to a value proportional to the input current I41. The two current mirror transistors in the depicted example are configured as p-channel MOSFETs, of which the input transistor 41 is wired as a diode.

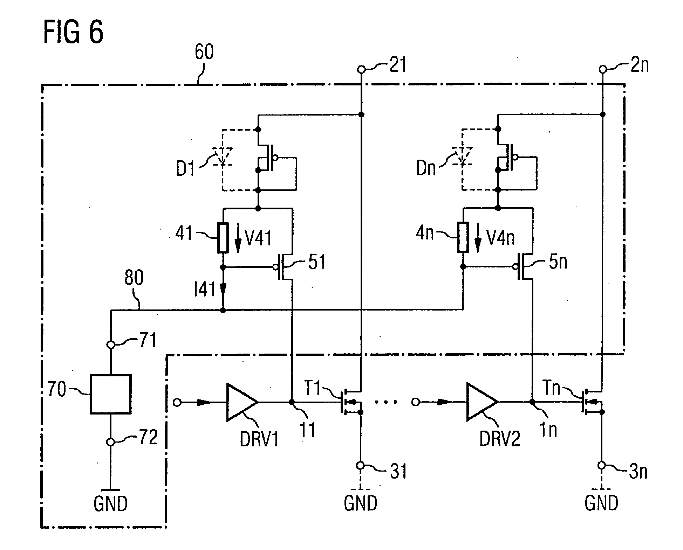

Another exemplary embodiment of the current sensors and the current sources is given in Figure 6. In this exemplary embodiment, the current sensor 41 of an actuating circuit is realized as an ohmic resistor, which are connected between the first load terminal 21 of the respective semiconductor switch T1 and the central circuit node 80. A current I41 flowing across this resistor 41 in event of an overload causes a voltage drop V41 across this resistor, which serves to actuate a transistor 51, whose load is connected between the first load terminal 21 and the control terminal 11 of the respective semiconductor switch T1. The transistor 51, 5n in this circuit according to Figure 6 functions as a current source and is configured in the example as a p-channel MOSFET.

Also a mixed solution comprising a current mirror and a resistor may be used as a current sensor. Referring to Figure 5 resistors 411, 411n may be connected between the rectifier elements D1, Dn and the gate terminals of the current mirror output transistors 51, 5n. These resistors serve to increase the robustness of the current sensors.

In the exemplary embodiment of Figure 6 the diodes D1, Dn are realized using the parasitic bulk - drain junction of a PMOS transistors. This permits an area saving since the diodes/rectifiers D1, Dn and the current sources 51, 5n can be placed into the same bulk.

The above-described overvoltage protection arrangement of the circuit according to the invention merely requires, for protection of the semiconductor switches, a voltage limiting unit realized by using one or more Zener diodes. This overvoltage protection arrangement has the benefit of being space-saving, given the need to provide only one voltage limiting unit. Furthermore, no problems caused by manufacturing variations can arise in this overvoltage protection arrangement.

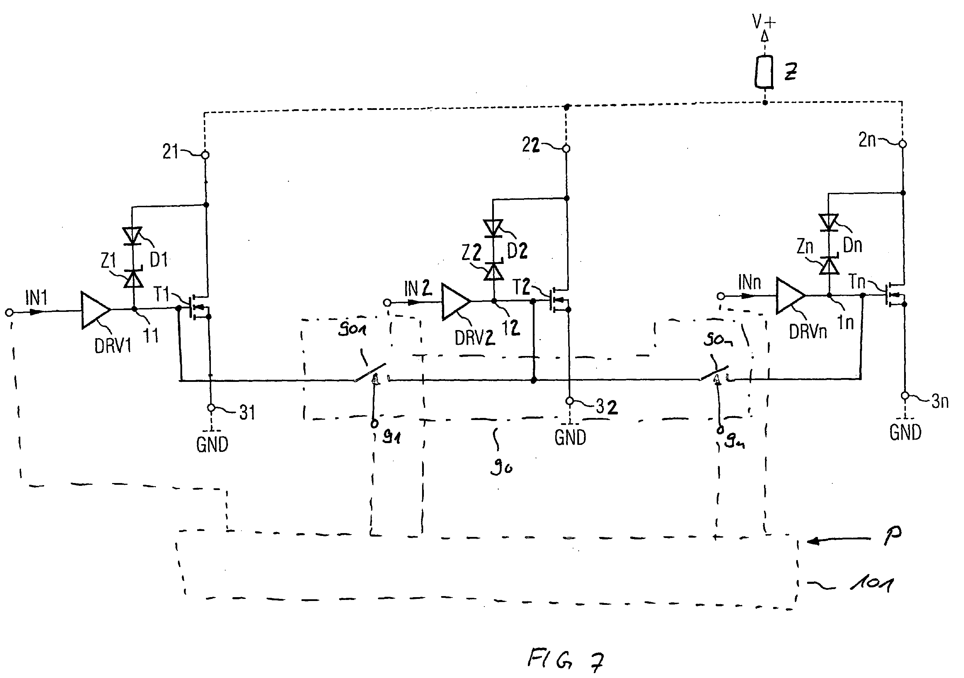

Referring to figure 7 current sharing between at least two semiconductor switches T1, T2, Tn connected in parallel for driving a common load Z may be improved by providing a coupling circuit 90. The coupling circuit serves for electrically coupling the control terminals 11, 12, 1n of the semiconductor switches T1, T2, Tn connected in parallel. The circuit arrangement of figure 7 comprises three semiconductor switches T1, T2, Tn each of which having a control terminal 11, 12, 1n and first and second load terminals 21, 22, 2n, 31, 32, 3n. The coupling arrangement 90 comprises a number of switches 901, 90n with each of these switches 901, 90n being connected between control terminals 11, 12, 1n of two semiconductor switches T1, T2, Tn and with each control terminal 11, 12, 1n being connected to only one switch 901, 90n. For connecting the control terminals of n (with n being an integer) semiconductor switches T1, T2, Tn, n-1 switches of the coupling arrangement 90 are required.

The switches 901, 90n of the coupling circuit have control terminals 91, 9n for applying switching signals. The switching signals which serve for switching on or off the switches 901, 90n may be provided by a control circuit 100 which also provides the input signals IN1, IN2, INn of the semiconductor switches T1, T2, Tn. The control circuit 100 is provided a control signal P including information on the semiconductor switches T1, T2, Tn to be actuated together for driving one common load Z. Depending on this control signal P the control circuits generates the switching signals for selectively switching on the switches 91, 9n thereby connecting the control 11, 12, 1n terminals of at least two semiconductor switches T1, T2, Tn.

The coupling circuit 90 improves current sharing/balancing between the semiconductor switches T1, T2, Tn which have their control 11, 12, 1n terminals connected by causing the same electrical potential at the control terminals 11, 12, 1n and thereby causing the transistors to be operated in the same operation point. This applies to a normal operation mode, when the semiconductor switches are switched on by input signals IN1, In2, INn, as well to an overvoltage protection mode, when the semiconductor switches T1, T2, Tn are switched on by overvoltage protection circuits.

In figure 7 each of the semiconductor switch has its own overvoltage protection circuit D1, Z1 D2, Z2, Dn, Zn being connected between the first load terminal 21, 22, 2n and the control terminal 11, 12, 1n. These overvoltage protection circuits may each have a diode D1, D2, Dn and a Zener diode Z1, Z2, Zn connected in series. In overvoltage protection mode, i.e. if the semiconductor switches T1, T2, Tn are normally switched off, the maximum voltage at the circuit node common to load Z and to the load paths of the semiconductor switches T1, T2, Tn is governed by the overvoltage protection circuit having the lowest activation voltage. However, due to the interconnection between the control terminals 11, 12, 1n each of the the semiconductor switches T1, T2, Tn connected in parallel is activated, thereby limiting the voltage at the common node. In general the activation voltages of the overvoltage protection circuits should be identical. However, variations may occur due to process variations in the manufacturing process of the circuit.

It should be mentioned that the control terminals 11, 12, 1n of the semiconductor switches are connected only then, if the switches T1, T2, Tn are to operated in parallel for driving one common load. Each of the switches T1,T2, Tn may drive its own load as well (not depicted). In this case the control terminals 11, 12, 1n are not connected, i.e. the switches 901, 90n are open. The number of switches to be switched in parallel may be chosen dependent on the load to be driven.

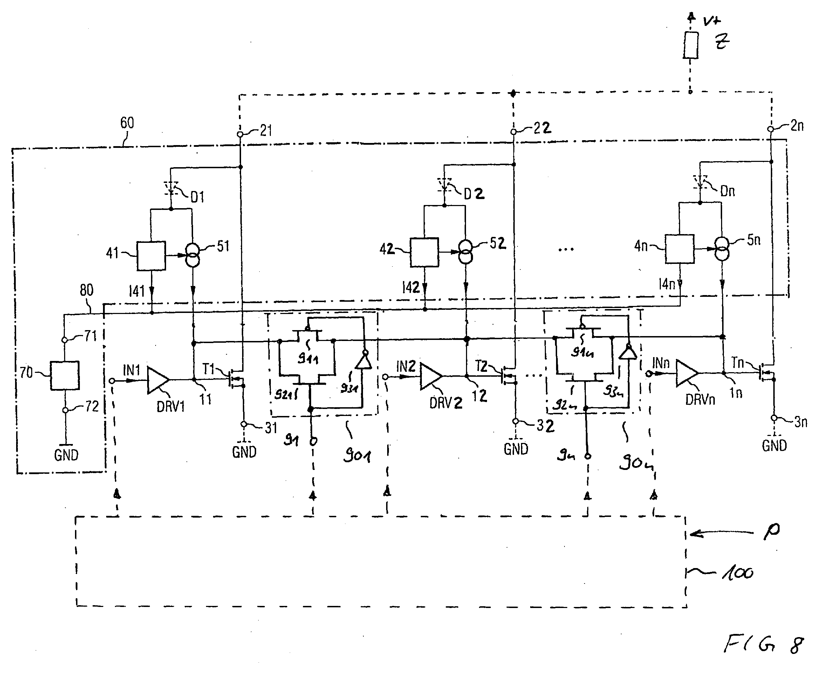

Referring to figure 8 the central overvoltage protection circuit 60 and the coupling circuit 90 may be implemented together in one circuit. Referring to figure 8 the switches 901, 90n of the coupling circuit may be so-called "transfer gates" each having a p-transistor 911, 91n and a n-transistor 921, 92n having their load paths (drain-source-paths) connected in parallel. One of theses transistors (the n-transistor 921, 92n in figure 8) is controlled directly by the control signal present at the control terminal 91, 9n, while the other one of these transistors (the p-transistor 911, 91n in figure 8) is controlled by the control signal via an inverter 931, 93n.

In the circuit of figure 8 the maximum voltage at the circuit node common to the load paths of the semiconductor switches T1, T2, Tn is governed by the central overvoltage protection 60. If the semiconductor switches are turned into conduction by overvoltage protection circuit 60 the coupling circuit helps to improve current sharing/balancing between the semiconductor switches T1, T2, Tn by effecting identical electrical potentials at their control nodes 11, 12, 1n.

### Reference numbers

- V+: positive power supply potential
- GND: reference potential
- IN1, INn: input signals
- DRV1, DRVn: driver circuits
- L: inductive load
- 11, 1n: control terminals, gate terminals
- Z1, Zn: Zener diodes
- D1, Dn: diodes
- 21, 2n: first load terminals
- 31, 3n: second load terminals
- T1, Tn: semiconductor switches, n-channel-MOSFET
- 60: overvoltage protection arrangement
- 80: central circuit node
- 70: voltage limiting unit
- 71, 72: terminals of the voltage limiting unit
- 81-83: Zener diodes
- 84: resistor
- V84: voltage
- 85: semiconductor switch, n-channel-MOSFET
- 411, 41n: resistors
- I41, I4n: currents
- V41, V4n: voltages
- 901, 90n: switches, transfer gates
- 911, 91n: p-transistor
- 921, 92n: n-transistor
- 931, 93n: inverter

## Claims

1. Circuit arrangement comprising
a first semiconductor switch (T1) and at least one second semiconductor switch (Tn), each of them having a control terminal (11, 1n) and a first (21, 2n) and second (31, 3n) load terminal, and with
at least one overvoltage protection arrangement for the at least two semiconductor switches (T1, Tn),
a coupling circuit (90) for selectively coupling the control terminals of at least two of the at least two semiconductor switches.

2. Circuit arrangement of claim 1 wherein the at least one overvoltage protection circuit comprises
a voltage limiting unit (70) with a first and a second terminal (71, 72), whose first terminal is connected to a central circuit node (80), whose second terminal is connected to a terminal for a reference potential (GND), and which is configured so that, when a threshold voltage is applied between the first and second load terminals (71, 72), it conducts a current, and the central circuit node (80) is coupled to the first load terminals (21, 2n) of the semiconductor switches (T1, Tn),
a first actuating circuit for the first semiconductor switch (T1) and a second actuating circuit for the at least one second semiconductor switch, each of the actuating circuits comprising a current sensor, which is connected between the first load terminal (21, 2n) of the particular semiconductor switch (T1, Tn) and the central circuit node, and a current source (51, 5n) which is actuated by the current sensor (41, 4n), being connected to the control terminal (11, 1n) of the particular semiconductor switch (T1, Tn).

3. Circuit arrangement according to Claim 2, in which the current limiting unit (70) has at least one Zener diode (81, 82, 83), having a load section, which are connected between the terminals (71, 72) of the voltage limiting unit (70).

4. Circuit arrangement according to Claim 3, in which the voltage limiting unit comprises several Zener diodes (81, 82, 83), each with a load section, whose load sections are connected in series between the terminals (71, 72) of the voltage limiting unit (70).

5. Circuit arrangement according to Claim 2, in which the voltage limiting unit (70) comprises:
- a semiconductor switch (85) with a control terminal and a load section, whose load section is connected between the terminals (71, 72) of the voltage limiting unit (70),
- an activation circuit (73) for the semiconductor switch (85), which is connected between the terminals (71, 72) of the voltage limiting unit and which is designed to make the semiconductor switch become conducting depending on a voltage between these terminals (71, 72).

6. Circuit arrangement according to Claim 5, in which the activation circuit (73) of the voltage limiting unit (70) has a series circuit with at least one Zener diode (81, 82, 83) and with a resistor (84), which is connected between the terminals (71, 72) of the voltage limiting unit (70), and the control terminal of the semiconductor switch (85) is connected to a node common to the at least one Zener diode (81, 82, 83) and the resistor (84).

7. Circuit arrangement according to one of claims 2 to 6, in which a rectifier (D1, Dn) is connected each time between the first load terminal of the first and second semiconductor switches (T1, Tn) and the central circuit node (80).

8. Circuit arrangement according to one of claims 2 to 7, in which the current sensor (41, 4n) and the current source (51, 5n) of an actuating circuit form a current mirror, which maps a current flowing from the first load terminal (21, 2n) of the particular semiconductor switch (T1, Tn) to the central circuit node (80) onto a current at the control terminal of the particular semiconductor switch (T1, Tn).

9. Circuit arrangement according to one of Claims 2 to 7, in which the current sensor (41, 4n) of an actuating circuit is realized as a resistor and the current source (51, 5n) is realized as a transistor, which is controlled by a voltage drop across the resistor (41, 4n).

10. Circuit arrangement of claim 1 wherein each of the semiconductor switches (T1, T2, Tn) comprises an overvoltage protection circuit D1, Z1, D2, Z2, Dn, Zn).
